# EUROPÄISCHE PATENTSCHRIFT

(11) **EP 4 385 293 B1**
(45) Veröffentlichungstag und Bekanntmachung des Hinweises auf die Patenterteilung: **16.07.2025**
(21) Anmeldenummer: 22786343.8
(22) Anmeldetag: 16.09.2022
(51) Int. Cl.: H05K 7/20, F28D 15/04, H01M 10/6552

(54) **THERMISCH LEITFÄHIGE HALTERUNG**
THERMALLY CONDUCTIVE SUPPORT
SUPPORT THERMOCONDUCTEUR

(30) Priorität: 30.09.2021 EP 21200229
(43) Veröffentlichungstag der Anmeldung: 19.06.2024
(73) Patentinhaber: Siemens Aktiengesellschaft, 80333 München (DE)
(72) Erfinder: MÜLLER, Volker, 90459 Nürnberg (DE); NEUGEBAUER, Stephan, 91058 Erlangen (DE); SCHWARZ, Florian, 90766 Fürth (DE); DANOV, Vladimir, 91056 Erlangen (DE); STEGMEIER, Stefan, 81825 München (DE)
(74) Vertreter: Siemens Patent Attorneys
(86) Internationale Anmeldenummer: PCT/EP2022/075791
(87) Internationale Veröffentlichungsnummer: WO 2023/052151

(56) Entgegenhaltungen:
- DE-A1- 102017 005 568
- US-A1- 2003 179 596

## Beschreibung

Die Erfindung betrifft eine Halterung, aufweisend eine erste Oberfläche zur Verbindung mit einer Wärmequelle und eine zweite Oberfläche zur Verbindung mit einer Wärmesenke. Ferner betrifft die Erfindung ein Verfahren zur Herstellung einer derartigen Halterung. Die Erfindung betrifft weiter einen Stromrichter mit mindestens einer derartigen Halterung.

Halterungen, insbesondere Halterungen aus Kunststoff, werden häufig zur Befestigung von elektrischen Komponenten genutzt, die unterschiedliches elektrisches Potential aufweisen. Dabei isoliert die Halterung diese Komponenten elektrisch voneinander. Diese Halterungen kommen häufig in Stromrichtern zum Einsatz und haben dort in der Regel zwei Funktionen. Zum einen dienen die Halterungen als mechanische Stütze, zum anderen dienen sie der elektrischen Isolation.

Eine Vielzahl von Kunststoffen weisen eine gute elektrische Isolationsfähigkeit auf. Jedoch haben Halterungen aus Kunststoff Nachteile im thermischen Verhalten, da sie nur eine niedrige thermische Leitfähigkeit aufweisen und somit icht zur Entwärmung beitragen können.

Mittlerweile sind auch Polymere als Kunststoffe mit verbesserter thermischer Leitfähigkeit im Bereich von 10W/mK bekannt. Dabei handelt es sich um Polymersysteme mit einem hohen Füllgrad an anorganischen Partikeln wie beispielsweise TiN, Al₂O₃, Si₃N₄ oder graphitischen bzw. diamantbasierten Schichten. Um die genannte thermische Leitfähigkeit zu erreichen, sind die anorganischen Partikel teils stäbchenförmig oder flächig ausgeführt, um möglichst wenig Kontaktfläche zu erhalten.

Aus der EP 3 475 978 B1 ist ein wärmeleitender Isolator bekannt. Zur Verbesserung seines Wärmeleitvermögens wird dort vorgeschlagen, den wärmeleitenden Isolator mit einem ersten Teil mit ersten Lamellen, die an mindestens einer Oberfläche des ersten Teils angeordnet sind, und einem zweiten Teil mit zweiten Lamellen, die an mindestens einer Oberfläche des zweiten Teils angeordnet sind, auszustatten. Dabei sind die ersten Lamellen und die zweiten Lamellen ineinandergreifend angeordnet, wobei zwischen dem ersten Teil und dem zweiten Teil zumindest im Bereich der Lamellen eine Isolationsschicht angeordnet ist.

Aus der DE 10 2017 005568 A1 ist eine Vorrichtung zum potentialfreien Wärmetransport zwischen Wärmequellen und Wärmesenken unterschiedlichen elektrischen Potentials bekannt, welche zumindest ein Wärmerohr umfasst. Ein hermetisch fluiddicht gegenüber der Umgebungsatmosphäre abgedichteter Arbeitsraum des Wärmerohres ist zumindest bereichsweise von zumindest einem ersten Teilbereich aus thermisch und elektacrisch gut leitendem Material, zumindest einem zweiten Teilbereich aus thermisch und elektrisch gut leitenden Material und zumindest einem dritten Teilbereich aus elektrisch isolierendem Material umschlossen ist, und wobei dritte Teilbereiche zwischen ersten Teilbereichen und zweiten Teilbereichen angeordnet sind und erste und zweite Teilbereiche infolge dieser Anordnung geometrisch und/oder elektrisch, zumindest mittelbar, voneinander isoliert sind.

Aus der US 2003/179596 A1 ist ein Wechselrichtermodul für elektrische Fahrmotoren bekannt. Der Wechselrichtermodul enthält einen Kühlkörper, der durch Löten elektrisch und thermisch mit einem Halbleiter verbunden ist.

Darüber hinaus haben sich Heatpipekühlkörper bereits seit Jahren für eine wirkungsvolle Kühlung auf dem Markt durchgesetzt. Dabei verdampft durch den Wärmeeintrag einer Wärmequelle in einem geschlossenen Rohr des Heatpipekühlkörpers eine Flüssigkeit. Durch das Vakuum im geschlossenen Rohr kondensiert die Flüssigkeit an einer anderen Stelle des Rohres, von der die Wärme dann beispielsweise an die Umgebungsluft abgegeben werden kann. Zum Zurückfließen der Flüssigkeit im Rohr wird der Kapillareffekt genutzt. Dafür wird die Innenseite des Rohres mit einer kapillaren Struktur bzw. einer porösen Struktur versehen.

Bei dem Betrieb einer pulsierenden Heatpipe, auch als oszillierende Heatpipe bezeichnet, wird die kapillare Struktur nicht benötigt. Die Innenseite des Rohres kann auch glatt ausgeführt sein. Auch bei der pulsierenden Heatpipe erfolgt die Wärmeübertragung über eine Flüssigkeit, wobei Teile der Flüssigkeit gasförmig im Rohr vorhanden ist. Aufgrund des Wärmeeintrags beginnt die Flüssigkeit im Rohr sich hin- und her zu bewegen. Dieses Pulsieren gibt der Heatpipe seinen Namen.

Der Erfindung liegt die Aufgabe zugrunde, die thermische Leitfähigkeit einer elektrisch isolierenden Halterung zu verbessern.

Diese Aufgabe wird durch eine Halterung, aufweisend eine erste Oberfläche zur Verbindung mit einer Wärmequelle und eine zweite Oberfläche zur Verbindung mit einer Wärmesenke gelöst, wobei die erste Oberfläche und die zweite Oberfläche jeweils durch ein Metallelement gebildet werden, wobei die Halterung ferner einen Körper aus einem Kunststoff, aus Glas oder aus Keramik aufweist, wobei der Körper sowohl an dem Metallelement der ersten Oberfläche als auch an dem Metallelement der zweiten Oberfläche anliegend angeordnet ist, wobei der Körper Durchgangsöffnungen aufweist, die sich vom Bereich der ersten Oberfläche zum Bereich der zweiten Oberfläche erstrecken, wobei die Halterung im Bereich der ersten Oberfläche und im Bereich der zweiten Oberfläche jeweils Nuten aufweist, die sich über zwei der Durchgangsöffnungen erstrecken, wobei die Metallelemente derart an dem Körper angeordnet sind, dass sich aus den Durchgangsöffnungen, den Nuten und den Metallelementen ein geschlossener Kühlkanal bildet. Ferner wird diese Aufgabe durch ein Verfahren zur Herstellung einer derartigen Halterung gelöst, wobei der Körper mittels eines Spritzgussverfahrens oder Fräsverfahrens gebildet wird, wobei anschließend der Körper im Bereich der ersten Oberfläche und im Bereich der zweiten Oberfläche metallisiert wird, wobei die Metallelemente jeweils mittels eines Lötverfahrens eines Schweißverfahrens oder eines Klebeverfahrens an dem metallisierten Bereich des Körpers befestigt werden. Die Erfindung wird weiter durch einen Stromrichter mit mindestens einer derartigen Halterung gelöst, wobei im Stromrichter ein Kondensator und/oder eine Stromschiene mittels der Halterung an einem Kühlkörper befestigt ist.

Weitere vorteilhafte Ausgestaltungen der Erfindung sind in den abhängigen Ansprüchen angegeben.

Der Erfindung liegt unter anderem die Erkenntnis zugrunde, dass sich die thermische Leitfähigkeit bei gleichzeitiger elektrischer Isolationsfähigkeit dadurch erreichen lässt, dass in einer Halterung mit einem Körper aus Kunststoff eine Kühlung nach dem Heatpipeprinzip integriert wird. Dazu kann das Prinzip einer gewöhnlichen Heatpipe genutzt werden, dass den Effekt des Verdampfens und des Rückflusses über eine poröse Struktur nutzt. Alternativ ist es möglich, das Prinzip einer Zweiphasenkühlung wie bei einer pulsierenden Heatpipe im Kunststoffkörper zu nutzen. Die Halterung weist dabei einen Körper auf, der einen Kunststoff oder Glas aufweist. Dabei kann der Körper vollständig aus Kunststoff bzw. Glas ausgebildet sein. Alternativ ist es möglich, nur Teile des Körpers aus Kunststoff oder Glas auszuführen. Vorteilhafterweise wird eine derartige isolierende Schicht aus Kunststoff oder Glas entlang der ersten und/oder zweiten Oberfläche sowie entlang der Durchgangsöffnungen ausgeführt. An den Stellen des Wärmeübergangs, also an den Kontaktstellen mit der Wärmequelle und mit der Wärmesenke weist die Halterung ein Metallelement auf, das den Wärmeübergang verbessert. Die elektrisch isolierende Eigenschaft wird durch den Körper aus Kunststoff erzielt. Dabei kann die erste Oberfläche oder die zweite Oberfläche als Metallelement ausgebildet sein. Alternativ ist es möglich, beide Oberflächen, d.h. die erste Oberfläche und die zweite Oberfläche jeweils als Metallelement auszuführen. Bei dem Metallelement kann es sich um einen in sich formstabilen Körper handeln. Alternativ ist es möglich, das Metallelement als dünne Schicht auf den Körper aufzubringen. Es hat sich herausgestellt, dass sich eine pulsierende Heatpipe auch innerhalb eines Körpers aus Kunststoff realisieren lässt. In dem Körper kann zusätzlich noch eine Sperrschicht angeordnet werden. Damit lässt sich ein Problem mit einer Sauerstoffdiffusion im Betrieb der pulsierenden Heatpipe zuverlässig verhindern. Diese Sperrschicht kann unter Verwendung eines anorganischen Materials oder speziellen Kunststofffolien gebildet werden. In diesem Fall ist es dann auch möglich, den Körper alternativ zum Kunststoff aus Glas oder Metall auszuführen. Wenn keine Anforderungen an eine elektrische Isolationsfestigkeit bestehen, ist auch eine Ausführung des Körpers als Metall möglich.

In dem Körper wird mindestens eine Durchgangsöffnung angeordnet. Diese kann mit einem porösen Material wie beispielsweise Metallschaum gefüllt sein. Durch den Kapillareffekt kann damit ein herkömmliches Heatpipeverhalten erzielt werden. Dies verbessert den Wärmetransport innerhalb der Halterung.

Alternativ ist es möglich, das Verhalten einer pulsierenden Heatpipe für die Wärmeübertragung zu nutzen. Dazu ist es vorteilhaft, wenn der Körper mehrere Durchgangsöffnungen aufweist, die sich vom Bereich der ersten Oberfläche zum Bereich der zweiten Oberfläche erstrecken. Durch eine Nut an der Oberfläche des Körpers, insbesondere am Ende der einzelnen Durchgangsöffnungen, werden zwei der Durchgangsöffnungen derart verbunden, dass sich mit den angebrachten Metallelementen ein geschlossener Kanal im Innern der Halterung bildet und einen geschlossenen Kühlkanal bildet. Dieser geschlossene Kühlkanal wird auch als geschlossener Kreislauf bezeichnet. Dabei müssen die Durchgangsöffnungen nicht notwendigerweise gradlinig im Körper verlaufen. Neben einer gradlinigen Verbindung haben sich auch sägezahnartige Verbindungen, Spiralverbindungen oder auch komplexe andere Verbindungen als vorteilhaft für die Ausbildung eines geschlossenen Kanals erwiesen.

Die Metallelemente sind an dem Körper befestigt. Dies kann insbesondere dadurch kostengünstig und einfach realisiert werden, indem der Körper mittels eines Spritzgussverfahrens hergestellt wird. Anschließend wird im Bereich der ersten Oberfläche und im Bereich der zweiten Oberfläche der Körper metallisiert. Dadurch lassen sich die Metallelemente auf einfache und kostengünstige Weise mittels eine Lötverfahrens oder eines Schweißverfahrens in diesem Bereich dauerhaft und zuverlässig an dem Körper befestigen. Dieses Verfahren ist nicht nur kostengünstig, sondern eignet sich auch für eine Massenproduktion. Darüber hinaus kann eine dauerhaft zuverlässige Verbindung zwischen dem Metallelement und dem Körper hergestellt werden, die der Halterung eine hohe Lebensdauer verleiht. Alternativ zum Löten oder Schweißen kann das Metallelement auch an den Körper geklebt werden.

Die Halterung kann beispielsweise in einem Stromrichter eingesetzt werden. In einem Stromrichter befinden sich zahlreiche elektrische Komponenten. Einige von diesen Komponenten erwärmen sich derart stark, dass Maßnahmen zum Abführen von Wärme erforderlich werden. Dazu werden beispielsweise Halbleiter auf Kühlkörper montiert. Darüber hinaus ergibt sich auch oftmals die Notwendigkeit, Wärme von Stromschienen und Kondensatoren abzuführen, damit diese Komponenten nicht in ihrer Auslegung die Leitungsfähigkeit des Stromrichters begrenzen oder reduzieren. Durch den Einsatz der vorgeschlagenen Halterung können diese Komponenten wie beispielsweise Stromschienen und Kondensatoren nicht nur sicher im Stromrichter befestigt werden und von vorhandenen anderen elektrischen Potentialen isoliert werden, sondern die Halterungen können auch zur Entwärmung, d.h. Kühlung bzw. Entzug von Wärme, bei diesen Komponenten beitragen. Dazu wird die betreffende Komponente wie beispielsweise Kondensator oder Stromschiene mittels des vorgeschlagenen Halters an einem Kühlkörper befestigt. Die Halterung bewirkt eine mechanisch feste Anordnung der Komponente im Stromrichter, eine hinreichende elektrische Isolation von vorhandenen elektrischen Potentialen und eine gute Entwärmung der Komponente. Besonders vorteilhaft ist es, eine Stromschiene in der Umgebung eines Wandlers, d.h. in einem Abstand von bis zu 25cm von dem Wandler anzuordnen und die Stromschiene damit zu befestigen. Im Bereich von Wandlern treten oftmals hohe Temperaturen auf. Zum einen, da der Wandler eine natürliche Konvektion verhindert, wenn er die Stromschiene umgibt, zum anderen, da der Wandler selbst noch zur Erwärmung beiträgt. Beispiele für Wandler sind Stromwandler und Spannungswandler.

Darüber hinaus kann unter Umständen durch die Entwärmung der Stromschiene mittels der vorgeschlagenen Halterung der Querschnitt der Stromschiene kleiner gewählt werden. Dadurch können kleinere Wandler verwendet werden und die Einbausituation in einem Schrank des Stromrichters entspannt sich. Gegebenenfalls kann der Stromrichter dadurch auch mit geringerer Baugröße hergestellt werden. Darüber hinaus erhöht sich durch diese Entwärmung die Lebensdauer bzw. die Leistungsfähigkeit des Stromrichters und der darin angeordneten Komponenten.

Die Halterung weist als Körper beispielsweise eine spritzgegossene Hülle auf, die mit einem Bodendeckel verklebt oder verschweißt ist. Der Bodendeckel wird vorzugsweise aus Gründen der thermischen Leitfähigkeit durch das Metallelement gebildet. Durch Bohrungen, das Einlegen, Einpressen oder Einkleben von Innenteilen oder auf sonstige Weise wird ein Kanal ausgeformt, der sich für den Betrieb einer pulsierenden Heatpipe oder einer gewöhnlichen Heatpipe eignet. Eine vollständige Dichtheit zwischen den Kanälen ist nicht zwingend notwendig. Die notwendigen Nuten zur Bildung des geschlossenen Kanals können in Innenteilen und/oder in den Körper und/oder in den Metallelementen, also den Bodendeckeln, eingebracht sein.

Vorteil gegenüber anderen Lösungen ist, dass die Fertigung ohne sehr schlanke Kerne im Werkzeug erfolgen kann, und die Kanäle für den Betrieb der pulsierenden Heatpipe flexibel an der Basis der Halterung eingebracht werden können. Weiterhin ist eine Ausführung mit vollständig geschlossener Kunststoffhülle des Körpers möglich, wenn hohe Isolationsanforderungen bestehen oder auch wenn eine Kostenersparnis angestrebt wird. Dann kann günstiger Kunststoff im inneren Bereich mit schlechteren Eigenschaften zur Anwendung kommen. Dann ist es aufgrund der schlechten Wärmeleitfähigkeit der Kunststoffe vorteilhaft, wenn die Kanäle im Bereich der ersten und zweiten Oberfläche großflächig ausgebildet sind. Sollen Metallbuchsen zur Befestigung eingesetzt werden, können diese ebenfalls zur Entwärmung beitragen. Der thermische Kontakt erfolgt also nicht nur an der Oberfläche der Halterung, sondern kann auch über die Befestigungsmittel im Kern erfolgen. Die Metallbuchse kann in einem Hohlraum des Körpers angeordnet werden und gibt dabei die Wärme per Wärmeleitung in den Kernbereich der Halterung weiter. Die Buchsen können hierbei so befestigt werden, dass sie in der Anwendung fast ausschließlich Scherspannungen ausgesetzt sind, die im Vergleich zu Zug- oder Schälbelastungen wesentlich besser tolerierbar bzw. ertragbar sind.

Dabei ist ein Aufbau mit einer geringeren Teileanzahl möglich. Hierdurch ist jedoch gegebenenfalls die Bodenfläche, also die Fläche, die das Metallelement bildet, nicht vollständig zur Entwärmung nutzbar oder die Einzelteile sind teurer in der Fertigung. Mindestens werden zwei Einzelteile benötigt.

Das verbleibende Innenvolumen in der Halterung kann für weitere Zwecke eingesetzt werden. Mit massivem Kern wird die Entwärmung bzw. Wärmeleitung im Material unterstützt und Wärmepufferung erreicht. Bei einer Füllung mit Phase-Change-Materialien ist darüber hinaus noch eine größere Wärmepufferung möglich. Wird zusätzliches Fluid als Reserve eingebracht, so lässt sich die Lebensdauer des Bauteils im Falle minimaler Diffusionsverluste oder Verunreinigungen signifikant verlängern.

Durch die besonders effektive Wärmeübertragung lassen sich auch besonders lange Halterungen mit hoher Wärmeleitfähigkeit herstellen. Auch Längen von über 25cm oder sogar über 50cm können mit hoher Wärmeleitfähigkeit von über 100W/mK hergestellt werden.

Bei einer vorteilhaften Ausgestaltung der Erfindung sind die Nuten im Metallelement angeordnet. Damit können die Durchgangsöffnungen des Körpers je nach Anforderungen mit Hilf des Metalldeckels an die Applikation angepasst werden.

Bei einer weiteren vorteilhaften Ausgestaltung der Erfindung befindet sich in dem Kühlkanal eine Flüssigkeit, wobei Teile der Flüssigkeit gasförmig im Kühlkanal vorhanden sind, wobei die Flüssigkeit ein dielektrisches Fluid darstellt. Dabei hat es sich als vorteilhaft erwiesen, wenn in den geschlossenen Kühlkanal ein Vakuum angeordnet ist. Dies lässt sich durch Evakuieren erzielen. Dann ist sichergestellt, dass die Flüssigkeit in hinreichendem Maße sowohl in ihrer flüssigen Form als auch in der gasförmigen Form vorliegt. Sollten sich besonders hohe Anforderungen an die elektrische Isolationsfestigkeit stellen, so hat es sich als vorteilhaft erwiesen, dielektrische Fluide in den geschlossenen Kühlkanal anzuordnen. Diese setzen die Isolationsfestigkeit zwischen den beiden Metallelementen nicht oder nur unwesentlich herab und stellen damit eine besonders hohe elektrische Isolationsfähigkeit der Halterung sicher.

Bei einer weiteren vorteilhaften Ausgestaltung der Erfindung sind die Halterung und der Körper zylinderförmig ausgebildet, wobei die erste Oberfläche und die zweite Oberfläche jeweils durch eine der Grundflächen des Zylinders gebildet wird, wobei die Metallelemente ringförmig ausgebildet sind. Durch die zylindrische Ausgestaltung lassen sich die Metallelemente auf besonders einfache Weise mittels eines Laserverfahrens dauerhaft an dem Körper befestigen. Durch die Zylinderform lässt eine saubere Verschmelzung zwischen Kunststoff und Metallelement erfolgen. Je nach Auswahl der für den Schweißvorgang verwendeten Wellenlänge und der Kunststoffe kann die Hitze exakt an der Grenzfläche appliziert werde. Alternativ zur Ausgestaltung als Deckel kann es vorteilhaft sein, anstelle des Metallelementes ein wärmeleitfähiges Polymer einzusetzen. Damit lassen sich der Körper und das Polymer auf einfache Weise mittels Verklebens dauerhaft miteinander verbinden.

Bei der Ausgestaltung der Zylinderform können die erste und die zweite Oberfläche einen beliebigen Winkel zueinander aufweisen. Das bedeutet, die erste und zweite Oberfläche müssen nicht notwendigerweise parallel angeordnet sein. Gegenüber einem zur Höhe senkrechten Schnitt durch den Zylinder können die erste und/oder zweite Oberfläche einen beliebigen Winkel aufweisen.

Die Zylinderform muss auch keinen kreisförmigen Querschnitt aufweisen. Alternativ zum kreisförmigen Querschnitt sind auch Querschnitte in einer ovalen Form oder als Vieleck, insbesondere als 6-eckig vorteilhaft und kostengünstig mit hoher mechanischer Stabilität ausführbar.

Bei einer weiteren vorteilhaften Ausgestaltung der Erfindung ist um die Mantelfläche des zylinderförmigen Körpers eine glasfaserverstärkte Kunststofffolie angeordnet. Diese Kunststofffolie erhöht die Druckfestigkeit der Halterung nach außen. Dadurch können für den Kunststoff des Körpers dann Polymere eingesetzt werden, die eine hohe chemische Beständigkeit gegenüber der Flüssigkeit im geschlossenen Kanal aufweisen, eine hohe thermische Stabilität aufweisen, sehr kostengünstig sind und keine hohe Druckstabilität aufweisen. Die Druckstabilität wird dann durch die glasfaserverstärkte Kunststofffolie erzielt. Damit ist die Halterung besonders kostengünstig herstellbar und kann auch über die gesamte Lebensdauer eine gute Wärmeleiteigenschaft aufrechterhalten.

Bei einer weiteren vorteilhaften Ausgestaltung der Erfindung ist in dem Kühlkanal ein Metallschaum angeordnet. Dieser Metallschaum dient als poröses Material dazu, die Kühlfunktion, also die Übertragung von Wärme, innerhalb des Körpers mit einer weiteren Zweiphasenkühlung zu erreichen. Diese kann anstelle der Kühlung nach dem Prinzip der pulsierenden Heatpipe geschehen oder auch in Kombination damit. Dazu wird eine poröse Struktur in dem geschlossenen Kanal angeordnet. Durch die poröse Struktur wird die Flüssigkeit unabhängig von der Einbaulage des Kühlkörpers zur Wärmequelle geführt. Dabei kann die poröse Struktur seitlich am Rand des Kanals angeordnet sein. Dann kann der Dampf durch den freien Teil des Kanals strömen. Alternativ kann die poröse Struktur vollständig ausfüllen, um den Effekt des Transportierens der Flüssigkeit mit hohem Durchsatz zu gewährleisten. Gerade wenn das Transportieren der Flüssigkeit gegen die Schwerkraft erfolgt, kann es vorteilhaft sein, den Kanal vollständig mit porösem Material zu füllen. Diese poröse Struktur kann durch einen Metallschaum oder durch einen Kunststoff, insbesondere durch einen additiv gefertigten Kunststoff, gebildet werden. Falls auch eine elektrische Isolationsfähigkeit der Halterung erforderlich ist, hat es sich bei der Verwendung von Metallschaum als vorteilhaft erwiesen, alternativ zum Metallelement ein elektrisch isolierendes Element, wie beispielsweise ein Kunststoffelement vorzusehen.

Bei einer weiteren vorteilhaften Ausgestaltung der Erfindung verkleinert sich der Querschnitt der Durchgangsöffnungen ausgehend vom Bereich der zweiten Oberfläche in Richtung zum Bereich der ersten Oberfläche. Durch die Verjüngung, also die Verkleinerung des Querschnitts, in Richtung zur Wärmequelle wird erreicht, dass sich die Flüssigkeit immer an der warmen Seite ansammelt und dadurch die Wärmeübertragung nicht nur eine hohe Leistungsfähigkeit aufweist, sondern auch leichter starten kann. Dies ist insbesondere dann von Vorteil, wenn die Schwerkraft der Ansammlung der Flüssigkeit im Bereich der Wärmequelle entgegenwirkt. Somit lässt sich durch die Verjüngung eine Halterung realisieren, die lageunabhängig eingesetzt werden kann.

Bei einer weiteren vorteilhaften Ausgestaltung der Erfindung sind Mittel zur Befestigung der Halterung an oder in dem Metallelement angeordnet. Das Metallelement hat eine derart hohe Festigkeit, dass dort die Anordnung von Befestigungsmitteln besonders vorteilhaft ist. Durch Einbringen eines Gewindes in das Metallelement lassen sich auch hohe Drehmomente für die Befestigung realisieren. Dabei können auch Gewindebuchsen und/oder Gewindebolzen zumindest teilweise an oder in dem Metallelement angeordnet sein. Die Halterung kann an beliebiger Stelle der Halterung angeordnet werden. Beispielsweise kann die Halterung am Metallelement oder auch am Körper oder an beiden dieser Komponenten angeordnet sein.

Bei einer weiteren vorteilhaften Ausgestaltung der Erfindung ist eine Gewindebuchse in dem Körper oder ein Gewindebolzen an dem Körper angeordnet. In den Körper kann eine Gewindebuchsen oder ein Gewindebolzen zur Befestigung eingebettet sein. Dieser oder diese kann dann zur Verschraubung mit einer Komponente wie beispielsweise einem Kondensator verwendet werden. Da oftmals keine hohen Drehmomente für die Verschraubung zulässig sind, kann auch die Anordnung der Verbindungsmittel im Kunststoff des Körpers, insbesondere in einem Hohlraum des Körpers, vorgesehen werden. Dieses Verbindungsmittel und die Anordnung im Körper sind zudem kostengünstig herstellbar. Wenn man den Schraubenantrieb beispielsweise auch an der Seite zugänglich macht und damit das Drehmoment direkt auf den Bolzen überträgt, kann auch mit größeren Drehmomenten verschraubt werden.

Bei einer weiteren vorteilhaften Ausgestaltung der Erfindung weist der Kühlkanals einen Querschnitt im Bereich von 0,25mm² bis 10mm² auf. In dieser Größenordnung kommt der Kapillareffekt der Heatpipe gegenüber der Schwerkraft hinreichend gut zur Geltung, so dass eine hinreichend gute Wärmeübertragung durch die Heatpipe, unabhängig ob mit oder ohne Ausnutzung des pulsierenden Effekts, sichergestellt werden kann.

Bei einer weiteren vorteilhaften Ausgestaltung der Erfindung weist das Metallelement eine Metallrippe auf, die in den Körper eingreift. Bei dieser Metallrippe kann es sich um eine Art Rohransatz handeln, der kreisförmig am Metallelement angeordnet ist. Dieser Rohransatz kann entweder in den Kanal hineinragen oder einen Teil des geschlossenen Kanals bilden. Durch die Metallrippe ist ein besonders guter Wärmeübergang zwischen den jeweiligen Oberflächen und der Flüssigkeit der Heatpipekühlung erzielbar. Der Vorteil lässt sich noch weiter verbessern, wenn die Metallrippe eine zusätzliche Struktur wie Dornen, einen Metallschaum oder Metallgewebe aufweist. Dies vergrößert die für den Wärmeübergang relevante Oberfläche und führt zu einer verbesserten Wärmeübertragung durch die Halterung.

Bei einer weiteren vorteilhaften Ausgestaltung der Erfindung weist das Metallelement eine weitere Metallrippe auf, die in den Kühlkanal derart eingreift, dass sich eine Grenzfläche zwischen Kühlkanal und Metallelement vergrößert. Auch diese Art der weiteren Metallrippe erhöht die für den Wärmeübergang relevante Oberfläche und führt zu einer verbesserten Wärmeübertragung durch die Halterung.

Bei einer weiteren vorteilhaften Ausgestaltung der Erfindung weist die Durchgangsöffnungen abschnittsweise eine Vergrößerung des Querschnitts auf, so dass sich ein Reservoir bildet. Dadurch können auf einfache Weise Vorratsreservoirs für die Flüssigkeit geschaffen werden. Damit kann einem möglichen Flüssigkeitsverlust entgegengewirkt werden.

Im Folgenden wird die Erfindung anhand der in den Figuren dargestellten Ausführungsbeispiele näher beschrieben und erläutert. Es zeigen:
- FIG 1 bis 9: verschiedene Ansichten und Ausführungsformen einer Halterung,
- FIG 10: ein Beispiel für die Anwendung der Halterung und
- FIG 11: eine schematische Darstellung eines Stromrichters.

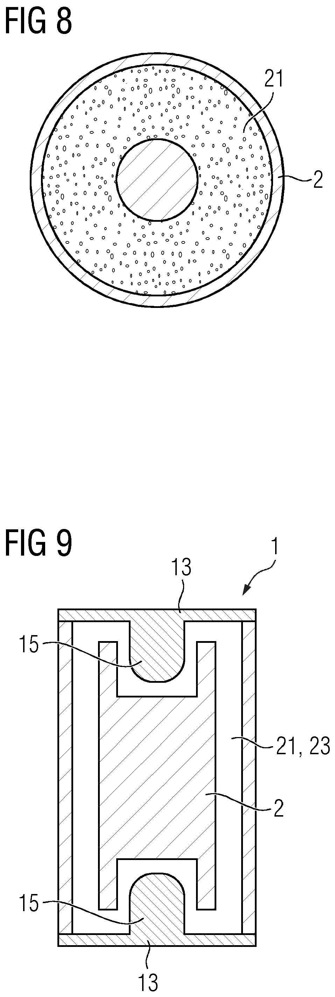

FIG 8 zeigt eine Halterung gemäß einem nicht beanspruchten Beispiel, das zum Verständnis des Hintergrunds der Erfindung hilfreich ist.

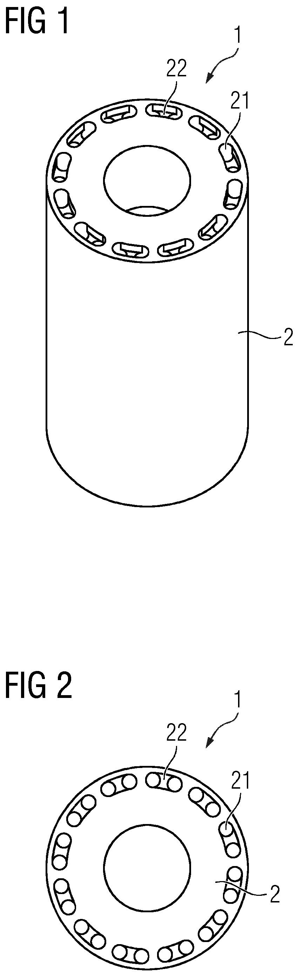

Die FIG 1 zeigt Teile einer Halterung 1. Die Halterung weist einen Körper 2 vorzugsweise aus einem Kunststoff auf. Dieser Kunststoff hat eine elektrisch isolierende Wirkung, jedoch eine schlechte thermische Leitfähigkeit. Um die thermische Leitfähigkeit zu verbessern, sind in dem Körper 2 Durchgangsöffnungen 21 angeordnet. Im Bereich der Grundflächen des zylinderförmigen Körpers 2 sind Nuten 22 derart bei den Durchgangsöffnungen angeordnet, dass sich aus den Durchgangsöffnungen 21 und den Nuten 22 ein geschlossener Kühlkanal 23 bildet. Die Mantelfläche des zylinderförmigen Körpers 2 kann zur Erhöhung der Druckfestigkeit noch mit einer glasfaserverstärkten Kunststofffolie umgeben sein.

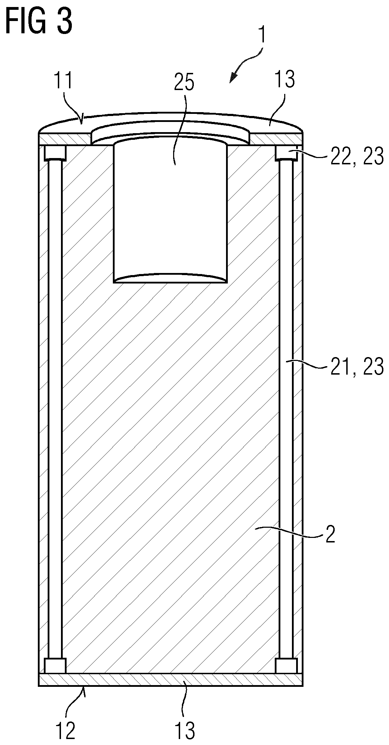

Die Durchgangsöffnungen 21 und Nuten 22 sind noch einmal genauer in FIG 2 dargestellt, wobei in dieser Darstellung die Sicht direkt auf die Grundfläche des zylinderförmigen Körpers 2 erfolgt. Die FIG 3 zeigt einen Schnitt durch die Halterung 1. Zur Vermeidung von Wiederholungen wird auf die Beschreibung zu den Figuren 1 und 2, sowie auf die dort eingeführten Bezugszeichen verwiesen. An den beiden Grundflächen des zylinderförmigen Körpers 2 ist jeweils eine Metallelement 13 angeordnet. Durch die Metallelemente 13 wird eine erste Oberfläche 11 zur Verbindung mit einer Wärmequelle und eine zweite Oberfläche 12 zur Verbindung mit einer Wärmesenke gebildet. In der Schnittdarstellung ist die Durchgangsöffnung 21 gut zu erkennen. Im Bereich der Grundfläche ist auch die Nut 22 zu erkennen, durch die sich ein geschlossener Kühlkanal 23 aus Durchgangsöffnung 21 und Nut 22 ergibt. In diesen geschlossenen Kühlkanal 23 ist ein Gemisch aus flüssigen und gasförmigen Anteilen einer Flüssigkeit angeordnet. Darüber hinaus ist der Kühlkanal evakuiert, so dass sich dort ein Vakuum befindet. Durch diese Ausgestaltung kann durch den geschlossenen Kühlkanal eine Heatpipekühlung, insbesondere eine pulsierende Heatpipekühlung, realisiert werden. Das Metallelement 13 ist als Ring ausgeführt. Dies erlaubt, in einem Hohlraum 25 des Körpers 2 eine Gewindebuchse anzuordnen, an dem eine elektrische Komponente befestigt werden kann. Dabei kann dieser Hohlraum 25 an beiden Grundflächen des Körpers 2 angeordnet sein.

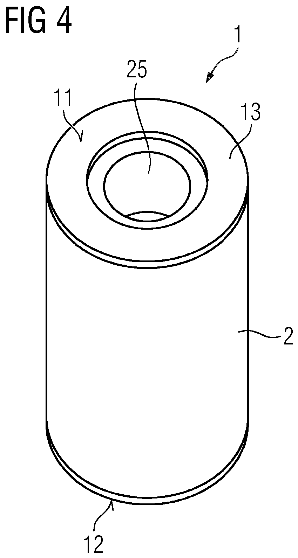

Die FIG 4 zeigt aus einer anderen Perspektive, wie das Metallelement 13, ausgeführt als Ring, an dem Körper 2 angeordnet ist. Zur Vermeidung von Wiederholungen wird auf die Beschreibung zu den Figuren 1 bis 3, sowie auf die dort eingeführten Bezugszeichen verwiesen.

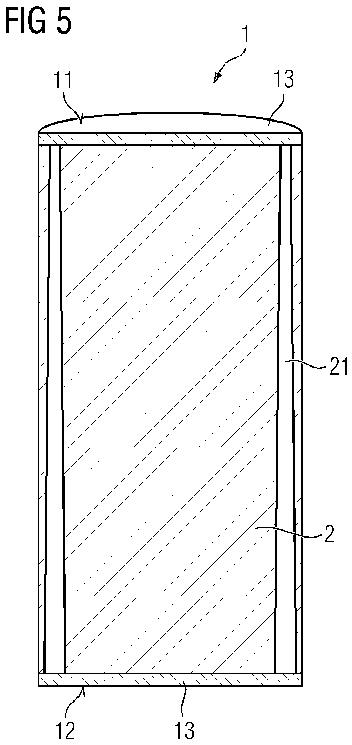

Die FIG 5 zeigt einen Schnitt durch ein weiteres Ausführungsbeispiel der Halterung 1. Zur Vermeidung von Wiederholungen wird auf die Beschreibung zu den Figuren 1 bis 4, sowie auf die dort eingeführten Bezugszeichen verwiesen. Dabei ist die erste Oberfläche 11 für die Verbindung mit einer Wärmequelle vorgesehen und die zweite Oberfläche 12 für die Verbindung mit einer Wärmesenke. Um die Kühlung langeunabhängig zu gestalten verjüngt sich die Durchgangsöffnung 21 von der zweiten Oberfläche 12 in Richtung zur ersten Oberfläche 11. Darüber hinaus hat sich für den lageunabhängigen Einsatz ein Querschnitt des geschlossenen Kühlkanals 23 im Bereich von 0,25mm² bis 10mm² als vorteilhaft erwiesen.

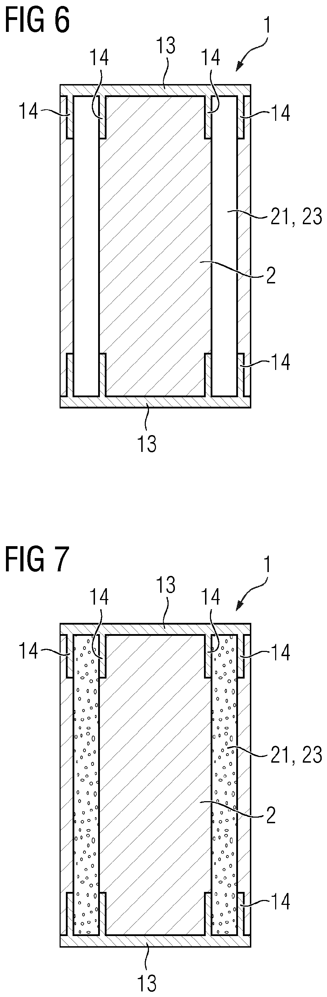

Die FIG 6 zeigt ein weiteres Ausführungsbeispiel einer Halterung 1. Zur Vermeidung von Wiederholungen wird auf die Beschreibung zu den Figuren 1 bis 5, sowie auf die dort eingeführten Bezugszeichen verwiesen. Dabei sind an den Metallelementen 13 jeweils mindestens eine Metallrippe 14 angeordnet. Diese ist vorzugsweise rund bzw. kreisförmig ausgebildet und greift derart in den Körper 2 ein, dass sich die Metallrippe 14 entlang des Kühlkanals 23, der sich aus der Durchgangsöffnung 21 und der Nut 21 ergibt, erstreckt. Dadurch wird ein besonders guter Wärmeübergang von der Wärmequelle zur Heatpipekühlung und von der Heatpipekühlung zur Wärmesenke erreicht.

Die FIG 7 zeigt ein weiteres Ausführungsbeispiel einer Halterung 1. Zur Vermeidung von Wiederholungen wird auf die Beschreibung zu den Figuren 1 bis 6, sowie auf die dort eingeführten Bezugszeichen verwiesen. Dabei sind die Durchgangsöffnungen 21 zum Teil oder vollständig mit einem porösen Material gefüllt. Dabei kann als poröses Material insbesondere ein Metallschaum in den Durchgangsöffnungen 21 angeordnet sein. Damit eignet sich die Halterung 1 nicht nur für die Übertragung von Wärme nach dem Prinzip einer pulsierenden oder oszillierenden Heatpipe, sondern auch nach dem Prinzip einer gewöhnlichen Heatpipe. Dabei können auch diese beiden Prinzipien in Kombination für den Wärmetransport in der Halterung 1 genutzt werden.

Für den Betrieb als gewöhnliche Heatpipe ist auch kein lang ausgedehnter Kühlkanal erforderlich. Vielmehr ist es hinreichend, nur eine Durchgangsöffnung 21, wie in FIG 8 dargestellt, im Körper 2 anzuordnen und diese, zumindest teilweise, mit einem porösen Material wie beispielsweise einem Metallschaum zu füllen.

Die FIG 9 zeigt ein weiteres Ausführungsbeispiel einer Halterung 1. Zur Vermeidung von Wiederholungen wird auf die Beschreibung zu den Figuren 1 bis 8, sowie auf die dort eingeführten Bezugszeichen verwiesen. Das Metallelement 13 weist dabei eine weitere Metallrippe 15 auf, welche die Grenzfläche zwischen dem Metallelement 13 und dem Kühlkanal 23 weiter erhöht. Dadurch wird der Wärmeübergang zwischen den Metallelementen 13 und der Heatpipekühlung weiter verbessert. Darüber hinaus ist es möglich, die weitere Metallrippe 15 im Metallelement 13 als ein Verbindungselement auszugestalten. So kann, beispielsweise in der weiteren Metallrippe 15 eine Gewindebohrung oder ein Bolzen angeordnet sein, mit dem die Halterung 1 mechanisch mit einer Komponente verbunden werden kann.

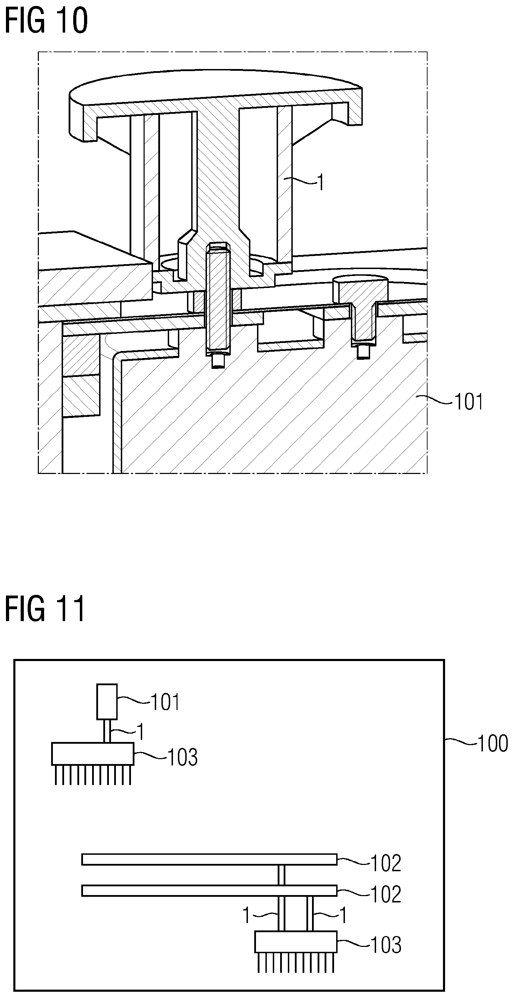

Eine derartige Verbindung zwischen einem Kondensator 101 als Wärmequelle und der Halterung 1 zeigt FIG 10. In dem Hohlraum 25 ist dabei ein Gewinde oder eine Gewindebuchse angeordnet mittels dessen bzw. derer die Halterung 1 und der Kondensator 101 mechanisch verbunden sind.

Die FIG 11 zeigt schematisch einen Stromrichter 100, der unter anderem einen Kondensator 101, Stromschienen 102 sowie Kühlkörper 103 aufweist. Mittels der Halterungen 1 ist der Kondensator 101 mit einem Kühlkörper 103 verbunden. Dieser Kühlkörper 103 kann in erster Linie zur Kühlung von anderen Komponenten, wie beispielsweise zum Kühlen von Halbleitern, dienen. Durch die Halterung 1 wird der Kondensator 101 im Stromrichter 100 befestigt. Darüber hinaus wird über die Halterung 1 Wärme an den Kühlkörper 103 übertragen. Mit anderen Worten wird der Kondensator 101 über die Halterung 1 von dem Kühlkörper 103 entwärmt bzw. gekühlt.

Das gleiche gilt für die Stromschienen 102. Mittels der Halterungen 1 sind die Stromschienen 102 fest im Stromrichter 100 angeordnet, also befestigt. Darüber hinaus übertragt die Halterung 1 Wärme von den Stromschienen 102 an die Kühlkörper 103. Besonders vorteilhaft ist die Anordnung der Halterung 1 im Bereich eines Wandlers. Da der Wandler die natürliche Konvektion behindern kann, ist in dem Bereich des Wandlers mit einer erhöhten Temperatur zu rechnen. Dieser Temperaturerhöhung durch den Wandler kann mit der Halterung 1 zuverlässig entgegengewirkt werden, wenn diese im Bereich des Wandlers angeordnet ist.

## Patentansprüche

1. Halterung (1), aufweisend
- eine erste Oberfläche (11) zur Verbindung mit einer Wärmequelle und
- eine zweite Oberfläche (12) zur Verbindung mit einer Wärmesenke,
wobei die erste Oberfläche (11) und die zweite Oberfläche (12) jeweils durch ein Metallelement (13) gebildet werden, wobei die Halterung ferner einen Körper (2) aus einem Kunststoff, aus Glas oder aus Keramik aufweist, wobei der Körper (2) sowohl an dem Metallelement (13) der ersten Oberfläche (11) als auch an dem Metallelement (13) der zweiten Oberfläche (12) anliegend angeordnet ist, wobei der Körper (2) Durchgangsöffnungen (21) aufweist, die sich vom Bereich der ersten Oberfläche (11) zum Bereich der zweiten Oberfläche (12) erstrecken, wobei die Halterung (1) im Bereich der ersten Oberfläche (11) und im Bereich der zweiten Oberfläche (12) jeweils Nuten (22) aufweist, die sich über zwei der Durchgangsöffnungen (21) erstrecken, wobei die Metallelemente (13) derart an dem Körper (2) angeordnet sind, dass sich aus den Durchgangsöffnungen (21), den Nuten (22) und den Metallelementen (13) ein geschlossener Kühlkanal (23) bildet.

2. Halterung (1) nach Anspruch 1, wobei die Nuten (22) im jeweiligen Metallelement (13) angeordnet sind.

3. Halterung (1) nach einem der Ansprüche 1 oder 2, wobei sich in dem Kühlkanal (23) eine Flüssigkeit befindet, wobei Teile der Flüssigkeit gasförmig im Kühlkanal (23) vorhanden sind, wobei die Flüssigkeit ein dielektrisches Fluid darstellt.

4. Halterung (1) nach einem der Ansprüche 1 bis 3, wobei die Halterung (1) und der Körper (2) zylinderförmig ausgebildet sind, wobei die erste Oberfläche (11) und die zweite Oberfläche jeweils durch eine der Grundflächen des Zylinders gebildet wird, wobei die jeweiligen Metallelemente (13) ringförmig ausgebildet sind.

5. Halterung (1) nach Anspruch 4, wobei um die Mantelfläche des zylinderförmigen Körpers eine glasfaserverstärkte Kunststofffolie angeordnet ist.

6. Halterung (1) nach einem der Ansprüche 1 bis 5, wobei in dem Kühlkanal (23) ein Metallschaum angeordnet ist.

7. Halterung (1) nach einem der Ansprüche 1 bis 6, wobei sich der Querschnitt der Durchgangsöffnungen (21) ausgehend vom Bereich der zweiten Oberfläche (12) in Richtung zum Bereich der ersten Oberfläche (11) verkleinert.

8. Halterung (1) nach einem der Ansprüche 1 bis 7, wobei Mittel zur Befestigung der Halterung (1) an oder in dem jeweiligen Metallelement (13) angeordnet sind.

9. Halterung (1) nach einem der Ansprüche 1 bis 8, wobei eine Gewindebuchse in dem Körper (2) oder ein Gewindebolzen an dem Körper (2) angeordnet ist.

10. Halterung (1) nach einem der Ansprüche 1 bis 9, wobei der Kühlkanals (23) einen Querschnitt im Bereich von 0,25mm² bis 10mm² aufweist.

11. Halterung (1) nach einem der Ansprüche 1 bis 10, wobei das jeweilige Metallelement (13) eine Metallrippe (14) aufweist, die in den Körper (2) eingreift.

12. Halterung (1) nach einem der Ansprüche 1 bis 11, wobei das jeweilige Metallelement (13) eine weitere Metallrippe (15) aufweist, die in den Kühlkanal (23) derart eingreift, dass sich eine Grenzfläche zwischen Kühlkanal (23) und jeweiligem Metallelement (13) vergrößert.

13. Halterung (1) nach einem der Ansprüche 1 bis 12, wobei die Durchgangsöffnungen (21) abschnittsweise eine Vergrößerung des Querschnitts aufweist, so dass sich ein Reservoir bildet.

14. Verfahren zur Herstellung einer Halterung nach einem der Ansprüche 1 bis 13, wobei der Körper (2) mittels eines Spritzgussverfahrens oder Fräsverfahrens gebildet wird, wobei anschließend der Körper im Bereich der ersten Oberfläche (11) und im Bereich der zweiten Oberfläche (12) metallisiert wird, wobei die Metallelemente (13) jeweils mittels eines Lötverfahrens, eines Schweißverfahrens oder eines Klebeverfahrens an dem metallisierten Bereich des Körpers (2) befestigt werden.

15. Stromrichter (100) mit mindestens einer Halterung (1) nach einem der Ansprüche 1 bis 13, wobei im Stromrichter (100) ein Kondensator (101) und/oder eine Stromschiene (102) mittels der Halterung (1) an einem Kühlkörper (103) befestigt ist.

## Claims

1. Mount (1), having
- a first surface (11) for connection to a heat source and
- a second surface (12) for connection to a heat sink,
wherein the first surface (11) and the second surface (12) respectively are formed by a metal element (13), wherein the mount also has a body (2) made of plastic, glass or ceramic, wherein the body (2) is arranged so as to abut against the metal element (13) of the first surface (11) and against the metal element (13) of the second surface (12), wherein the body (2) has through-openings (21) which extend from the region of the first surface (11) to the region of the second surface (12), wherein the mount (1) has grooves (22) in the region of the first surface (11) and in the region of the second surface (12) respectively, which grooves extend over two of the through-openings (21), wherein the metal elements (13) are arranged on the body (2) such that a closed cooling channel (23) is formed by the through-openings (21), the grooves (22) and the metal elements (13).

2. Mount (1) according to claim 1, wherein the grooves (22) are arranged in the respective metal element (13).

3. Mount (1) according to one of claims 1 or 2, wherein there is a liquid in the cooling channel (23), wherein parts of the liquid are present in gaseous form in the cooling channel (23), wherein the liquid is a dielectric fluid.

4. Mount (1) according to one of claims 1 to 3, wherein the mount (1) and the body (2) are cylindrical, wherein the first surface (11) and the second surface are each formed by one of the base areas of the cylinder, wherein the respective metal elements (13) are annular.

5. Mount (1) according to claim 4, wherein a glass-fibre-reinforced plastic film is arranged around the lateral surface of the cylindrical body.

6. Mount (1) according to one of claims 1 to 5, wherein a metal foam is arranged in the cooling channel (23).

7. Mount (1) according to one of claims 1 to 6, wherein the cross-section of the through-openings (21) decreases in the direction of the region of the first surface (11) starting from the region of the second surface (12).

8. Mount (1) according to one of claims 1 to 7, wherein means for fastening the mount (1) are arranged on or in the respective metal element (13).

9. Mount (1) according to one of claims 1 to 8, wherein a threaded bushing is arranged in the body (2) or a threaded bolt is arranged on the body (2).

10. Mount (1) according to one of claims 1 to 9, wherein the cooling channel (23) has a cross-section in the range of 0.25mm² to 10mm².

11. Mount (1) according to one of claims 1 to 10, wherein the respective metal element (13) has a metal rib (14) which engages in the body (2).

12. Mount (1) according to one of claims 1 to 11, wherein the respective metal element (13) has a further metal rib (15) which engages in the cooling channel (23) in such a way that an interface between the cooling channel (23) and the metal element (13) is enlarged.

13. Mount (1) according to one of claims 1 to 12, wherein the through-openings (21) have an enlargement of the cross-section in sections, so that a reservoir is formed.

14. Method for producing a mount according to one of claims 1 to 13, wherein the body (2) is formed by means of an injection moulding method or a milling method, wherein the body is subsequently metallised in the region of the first surface (11) and in the region of the second surface (12), wherein the metal elements (13) are each fastened to the metallised region of the body (2) by means of a soldering method, a welding method or an adhesive method.

15. Converter (100) with at least one mount (1) according to one of claims 1 to 13, wherein in the converter (100) a capacitor (101) and/or a power rail (102) is fastened to a heat sink (103) by means of the mount (1).

## Revendications

1. Support (1), comportant
- une première surface (11) de liaison à une source de chaleur et
- une deuxième surface (12) de liaison à un puits de chaleur,
dans lequel la première surface (11) et la deuxième surface (12) sont formées respectivement d'un élément (13) métallique, dans lequel le support a en outre un corps (2) en matière plastique, en verre ou en céramique, dans lequel le corps (2) est monté de manière à s'appliquer tant à l'élément (13) métallique de la première surface (11) qu'également à l'élément (13) métallique de la deuxième surface (12), dans lequel le corps (2) a des ouvertures (21) de passage, qui s'étendent de la partie de la première surface (11) à la partie de la deuxième surface (12), dans lequel le support (1) a, dans la partie de la première surface (11) et dans la partie de la deuxième surface (12), respectivement des rainures (22), qui s'étendent sur deux des ouvertures (21) de passage, dans lequel les éléments (13) métalliques sont disposés sur le corps (2), de manière à former un conduit (23) de refroidissement sans fin à partir des ouvertures (21) de passage, des rainures (22) et des éléments (13) métalliques.

2. Support (1) suivant la revendication 1, dans lequel les rainures (22) sont disposées dans l'élément (13) métallique respectif.

3. Support (1) suivant l'une des revendications 1 ou 2, dans lequel un liquide se trouve dans le conduit (23) de refroidissement, dans lequel des parties du liquide sont présentes sous forme gazeuse dans le conduit (23) de refroidissement, dans lequel le liquide représente un fluide diélectrique.

4. Support (1) suivant l'une des revendications 1 à 3, dans lequel le support (1) et le corps (2) sont constitués sous la forme de cylindre, dans lequel la première surface (11) et la deuxième surface sont formées respectivement par l'une des surfaces de base du cylindre, dans lequel les éléments (13) métalliques respectifs sont de constitution annulaire.

5. Support (1) suivant la revendication 4, dans lequel autour de la surface latérale du corps de forme cylindrique est disposée une feuille en matière plastique renforcée par de la fibre de verre.

6. Support (1) suivant l'une des revendications 1 à 5, dans lequel une mousse métallique est disposée dans le conduit (23) de refroidissement.

7. Support (1) suivant l'une des revendications 1 à 6, dans lequel la section transversale des ouvertures (21) de passage diminue à partir de la partie de la deuxième surface (12) en direction de la partie de la première surface (11).

8. Support (1) suivant l'une des revendications 1 à 7, dans lequel des moyens de fixation du support (1) sont disposés sur ou dans l'élément (13) métallique respectif.

9. Support (1) suivant l'une des revendications 1 à 8, dans lequel une douille taraudée est disposée dans le corps (2) ou un boulon fileté est disposé dans le corps (2).

10. Support (1) suivant l'une des revendications 1 à 9, dans lequel le conduit (23) de refroidissement a une section transversale dans la plage de 0,25 mm² à 10 mm².

11. Support (1) suivant l'une des revendications 1 à 10, dans lequel l'élément (13) métallique respectif a une nervure (14) métallique, qui pénètre dans le corps (2).

12. Support (1) suivant l'une des revendications 1 à 11, dans lequel l'élément (13) métallique respectif a une autre nervure (15) métallique, qui pénètre dans le conduit (23) de refroidissement, de manière à agrandir une surface limite entre le conduit (23) de refroidissement et l'élément (13) métallique respectif.

13. Support (1) suivant l'une des revendications 1 à 12, dans lequel les ouvertures (21) de passage ont par endroits un agrandissement de la section transversale, de manière à former un réservoir.

14. Procédé de fabrication d'un support suivant l'une des revendications 1 à 13, dans lequel on forme le corps (2) au moyen d'un procédé de moulage par injection ou d'un procédé de fraisage, dans lequel ensuite on métallise le corps dans la partie de la première surface (11) et dans la partie de la deuxième surface (12), dans lequel on fixe les éléments (13) métalliques respectivement au moyen d'un procédé de brasage, d'un procédé de soudage ou d'un procédé de collage, à la partie métallisée du corps (2).

15. Convertisseur (100) comprenant un support (1) suivant l'une des revendications 1 à 13, dans lequel, dans le convertisseur (100), un condensateur (101) et/ou une barre (102) de courant est fixé à un corps (103) de refroidissement au moyen du support (1).
